# EUROPEAN PATENT SPECIFICATION

(11) **EP 3 823 809 B1**
(45) Date of publication and mention of the grant of the patent: **03.05.2023**
(21) Application number: 18759734.9
(22) Date of filing: 17.07.2018
(51) Int. Cl.: B29C 51/00, B29K 105/00, B29K 507/04, B29K 75/00, B29L 31/00, B29C 51/02, B29C 51/10, B29C 51/42, H01L 21/67, B29C 48/00, B29C 48/90, B29C 48/07, B29C 48/87, B29C 48/88

(54) **PROTECTIVE STACKABLE TRAY FOR ELECTROSTATIC DISCHARGE SENSITIVE DEVICES USING SHAPE MEMORY POLYMERS AND A METHOD OF MANUFACTURING THE TRAY**
STAPELBARE SCHUTZSCHALE FÜR GEGENÜBER ELEKTROSTATISCHER ENTLADUNG EMPFINDLICHE VORRICHTUNGEN MIT FORMGEDÄCHTNISPOLYMEREN UND VERFAHREN ZUR HERSTELLUNG DER SCHALE
PLATEAU EMPILABLE DE PROTECTION POUR DISPOSITIFS SENSIBLES À LA DÉCHARGE ÉLECTROSTATIQUE UTILISANT DES POLYMÈRES À MÉMOIRE DE FORME ET MÉTHODE DE FABRICATION DU PLATEAU

(30) Priority: 16.07.2018 PT 2018110849
(43) Date of publication of application: 26.05.2021
(73) Proprietor: Bosch Car Multimedia Portugal, S.A., 4705-820 Braga (PT); Universidade do Minho, 4704-553 Braga (PT)
(72) Inventor: RIBEIRO DA SILVA, Cátia Samanta, 4800-058 Guimarães (PT); CARDOSO LIMA, André Manuel, 4800-058 Guimarães (PT); DO CÉU GRAMAXO OLIVEIRA SAMPAIO, Álvaro Miguel, 4800-058 Guimarães (PT); VILELA PONTES, António José, 4800-058 Guimarães (PT); FERREIRA RODRIGUES, Sérgio José, 4800-058 Guimarães (PT); FERNANDES FERREIRA GONÇALVES, Luís Filipe, 4800-058 Guimarães (PT); PINTO DA COSTA OLIVEIRA, Luís Filipe, 4705-820 Braga (PT); SAMPAIO DE ABREU FERNANDES, André Armindo, 4705-820 Braga (PT)
(74) Representative: Neves, Ana
(86) International application number: PCT/IB2018/055297
(87) International publication number: WO 2020/016627

(56) References cited:
- EP-A1- 0 165 255
- EP-B1- 1 755 849
- US-A- 4 945 127
- US-A1- 2005 274 455
- US-A1- 2009 242 108
- US-A1- 2010 301 512
- US-A1- 2017 259 951

## Description

### Technical field

The present application relates to a stackable tray for the storage and transport of electrostatic discharge sensitive devices (ESDS).

### Background art

Electronic products integrate complex functional systems, e.g. printed circuit boards, integrated circuits, which are susceptible to damage from mechanical shocks, vibrations, and discharges of accumulated electrostatic discharge, being classified as ESDS. The damage by an electrostatic discharge (ESD) is not perceptible until the electronic product is fully assembled and tested for operation. The prevention for this type of failure could consider testing each functional system, previous to the assembly, but with additional time and cost associated. Consequently, the storage and transport of ESDS became very important in the production of electronic assemblies, which lead to the development and adoption of more suitable methods and equipment for the storage and transport of these functional systems.

A considerable effort was directed towards the development of concepts and packaging materials capable of protecting ESDS from electrostatic discharge damage. Part of this effort has been aimed mainly at improving the dissipation of electrostatic charges and fields in materials with high application potential as packaging solutions, as exemplified in U.S. Pat. No. 2004/0259966A1, U.S. Pat. No. 2009/0242845A1 and U.S. Pat. No. 2015/0274924A1 while another part was focused at the development of packaging solutions suitable for storing and transporting the ESDS, as exemplified in U.S. Pat. No. 5,107,989, U.S. Pat. No. 6,401,930B and U.S. Pat. No. 5,201,415.

A common packaging system solution employed in companies nowadays consists of a tote box with smooth interior and a lid, as in U.S. Pat. No. 2011/0127275 A1 and U.S. Pat. No. 2017/0001756 A1, and stackable trays stored within the tote box.

Stackable trays are the most critical part of the packaging system as there is direct contact with the ESDS fragile components. Typically, stackable trays are fabricated by means of injection moulding technology, as in U.S. Pat. No. 2003/0209466A1 and U.S. Pat. No. 6,202,883 B1, thermoforming technology, as in WO2012003148A2 and EP2588533A2, or by the combination of both, as in U.S. Pat. No. 6,612,442 B2. The thermoforming technology is the simpler and most cost affordable technique. Stackable trays are commonly designated as dedicated due to the specificity of the design and fabrication for each particular ESDS configuration. This way, it is assured the best accommodation while avoiding free movement, providing substantial mechanical and electrostatic/electromagnetic protection. These dedicated systems have been extensively used to store and transport ESDS or components. For instance, U.S. Pat. No. 7,410,060, and U.S. Pat. No. 6,868,970B2 disclose a tray to restrain and stabilize integrated circuits based on specific features such as an upper and lower side presenting support elements, forming ledges and ridges. U.S. Pat. No. 5,474,178A presents a dedicated tray with housings of different lengths, for the support of electrical connectors with variable sizes. U.S. Pat. No. 5,794,784 reports a tray for the storage and transportation of multiple pin grid array (PGA) integrated circuit components each having a planar housing and plurality of terminal pins arranged in spaced rows. The tray has a framework for supporting upstanding ribs that engage the integrated circuit component. Each upstanding rib lies along an axis in one of two sets of intersecting axes and aligns with and fits between certain spaced rows to support the bottom of the components.

ESDS configuration is widely variable in accordance to the application purpose of the assembled electronic product. The use of stackable dedicated trays for a specific ESDS greatly improves the safe storage and transport, although it also means that specific trays must be constantly produced for the new electronic systems, while others turn obsolete and the dedicated trays become waste that requires recycling. Furthermore, companies typically produce variable electronic products simultaneously, meaning that several stackable dedicated trays with various design configurations are at use or waiting for use occupying storage area. This means more lead times for the fabrication of new stackable dedicated trays and recycling of no longer necessary ones, larger number of packaging systems and areas allocated for storage which, consequently, increases the associated costs. These features created the need for the development of a new approach based on the concept of recovery of the stackable dedicated trays of discontinued ESDS to be employed in the fabrication of new stackable dedicated trays. This process is not possible by employing typical thermoplastic materials and, therefore, a specific type of material was considered, a shape memory polymer. Shape memory polymers are smart materials which present the ability to "memorize" a permanent (original) shape that can be manipulated to a certain temporary shape (deformed state), and recover the original shape by the imposition of an appropriate stimulus (e.g. temperature, pH, light, magnetic), which functions as a trigger. This type of material finds applications in various fields. For instance, U.S. Pat. No. 2012/0119417 discloses a method and a support apparatus for providing structural support to a mould or mandrel that integrates parts made with shape memory polymer. EP 3266726 A1 discloses a container for processing and/or transporting biopharmaceutical fluids which comprises a shape memory material, polymer or alloy inside the walls being adapted to change shape when induced by an external stimulus, so that the container can be alternately in a collapsed state or in an unfolded state. The shape memory material allows the container to easily change shape and can thus contain the biopharmaceutical fluid in the unfolded state or be stored in the collapsed state while saving space. U.S. Pat No. 8,733,071 B2 and U.S. Pat. No. 2010/0301512 A1 disclose a packaging method based in a shape memory polymer. This method involves placing a part adjacent to shape memory polymer in its permanent shape, heating the shape memory polymer to a temperature above its switching temperature, and applying a force to the heated shape memory polymer such that the polymer switches from its permanent shape into a temporary shape. The temporary shape corresponds to the desired shape for the packaging of the part and is maintained by cooling the shape memory polymer to a temperature below its switching temperature. In some cases, the packaging is formed completely from the shape memory polymer, in other examples the packaging is formed from a combination of the shape memory polymer and the non-shape memory material.

Disclosures US4945127A, US2010301512A1 and US2005274455A1 disclose trays and processes in accordance with the preambles of claims 1 and 5.

### Summary

The present application relates to a protective stackable tray for electrostatic discharge sensitive devices in accordance with claim 1.

In one embodiment the shape memory polymer composite is polyurethane based.

In another embodiment the shape memory polymer composite is polyethylene based.

In yet another embodiment the anti-static additive compound consists of a masterbatch which comprises partial polymeric matrix based in the shape memory polymer and additives selected from carbon black or carbon nanotubes.

The present application also relates to a process to produce the stackable tray for electrostatic discharge sensitive devices in accordance with claim 5.

In one embodiment the temperature range inside the heated barrel varies from 50°C near the hopper to 230°C near the die.

In another embodiment the polymeric sheet is softened at a temperature that ranges between 40°C to 80°C.

In yet another embodiment the anti-static additive compound is used in a percentage between 1% and 8% in relation to the shape memory polymer weight.

### General description

Stackable trays are fabricated with materials that provide electrostatic discharge (ESD) protection and, with such design features and configurations that, the electrostatic discharge sensitive devices (ESDS), such as integrated circuits, PCBs, electronic components, are placed in a singular position, perfectly fitting into dedicated cavities reducing this way, damage probability due to exceeding strain or stress over fragile components and solder joints. Within the increasing demand for new products, the ESDS configurations are constantly being altered and, due to the high specificity of stackable trays, it becomes necessary to design and fabricate new stackable trays.

The present application discloses a stackable tray based on a shape memory composite, with electrostatic dissipative properties, that is processed by means of sheet extrusion to generate the permanent shape. The permanent shape can be altered, by a combination of heating above the switching temperature followed by the application of a force, changing into a temporary shape that presents a series of pre-defined features that assure the perfect fitting of the ESDS. When is necessary to change the design configuration of the stackable tray, it is possible to recover the permanent shape by heating above the switching temperature and thermoform the material into a new temporary shape.

The modification of polymeric materials by the inclusion of e.g. additives and fibres is common. Still, the integration of antistatic additives into shape memory polymers to obtain a shape memory composite with electrostatic dissipative properties is highly innovative bringing advantages for a wide range of application fields. Applications where electrostatic discharge protection is mandatory are increasing and therefore, the present application has the potential to improve processes and protect ESDS from premature damage.

The simple change in the processing method to include a modified shape memory polymer completely alters the product life time and possibilities of use for variable ESDS configurations. The fabrication process is greatly improved by the recoverability and reprocessing ability being, therefore, a versatile solution which provides waste reduction, reutilization of material, shorter lead times, dimensional accuracy, feasibility, and the assurance of ESD and strain/stress protection to such sensitive products.

The main features of the present technology are:
- The use of a shape memory material to build up a stackable dedicated tray allows the recoverability and reprocessing (reusability) of the tray for a new electronic product, while assuring process reproducibility in terms of dimensional accuracy and material properties maintenance;
- Shape memory polymer modification, by the integration of an anti-static additive compound, to obtain a material that provides ESD protection at the electrostatic dissipative range assuring this way, the protection of ESDS from electrostatic discharges and fields. Even when changing between permanent shape to temporary shape and vice-versa, the ESD protection is assured;
- The processing method for the stackable dedicated tray is based in extrusion moulding where the anti-static additive compound is integrated and homogenised with the shape memory polymer to create the permanent (original shape). Temporary shape is based in thermoforming technology allowing the definition of specific features with a simple technology;
- The use of such material to fabricate stackable trays improves the logistics associated by reducing lead times, allocated storage areas, and recycle need.

### Brief description of drawings

For easier understanding of this application, figures are attached in the annex that represent forms of implementation which nevertheless are not intended to limit the technique disclosed herein.

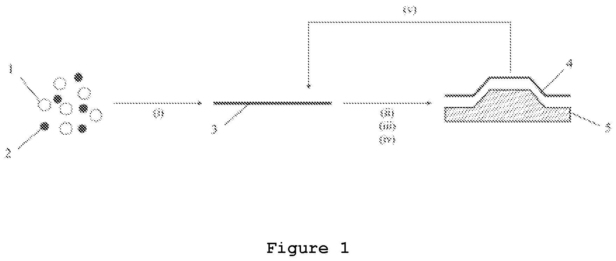

Figure 1 shows the process cycle representation for the stackable tray based on a shape memory polymer composite. The references are as follows: 1 - shape memory polymer, 2 - anti-static additive compound, 3 - permanent shape, 4 - temporary shape, 5 - mould structure, i - sheet extrusion, ii - heating, iii - thermoforming, iv - cooling, v - Shape recovery (heating).

### Description of embodiments

Now, embodiments of the present application will be described with reference to the annexed drawings. However, they are not intended to limit the scope of this application.

The solution disclosed herein provides a stackable dedicated tray which can be conformed to a temporary shape, and has the ability to recover the original shape, allowing its reusability for another temporary shape configuration. The solution is based on a shape memory polymer composite, which can be triggered by a thermal stimulus, and integrates an anti-static additive compound for the achievement of electrostatic discharge properties at the electrostatic dissipative range, surface resistance between 105 Ω and 108 Ω, assuring this way, protection of ESDS from electrostatic discharges.

The technology disclosed herein may be used to suitably accommodate ESDS for transport, where such packaging solution advantageously protects the product from environmental effects e.g., electrostatic discharges and fields, vibrations and shocks that may lead to premature failure. The present technology may be reused for the same part and, when necessary, it also enables the packaging of different configurations of ESDS, after appropriate reprocessing by heating and re-conforming a shape memory polymer to a new configuration. As such, the ability of reconfiguration disclosed herein is generally easier, and involves shorter lead times than conventional processing methods for stackable trays.

The process to produce the presently disclosed tray comprises a step of definition of the permanent shape and a step to generate the temporary shape, comprising the following sub-steps:
Definition of the permanent shape:
- mixing of anti-static additive compound with the shape memory polymer;
- the raw material mixture is provided to the extrusion machine;
- the material is both melted and trans versed along by the action of a rotary screw inside a heated barrel;
- the molten polymer is forced into a die, which generates a constant cross section shape in the continuous length of the extruded polymeric sheet;
- the extruded polymeric sheet is hardened by cooling while simultaneously being pulled by adjacent rollers;
- the extruded polymeric sheet is then cut to size Generation of the temporary shape;
- the polymeric sheet is softened, by heat radiation, until a pliable forming temperature is reached;
- the softened sheet is pressed against a mould structure mechanically and by means of vacuum, acquiring a specific shape;
- the moulded sheet is cooled while maintaining the shape.

The temporary shape can be reverted to the permanent shape by exposing the tray to an appropriate stimulus, which induces the recovery phenomenon to the permanent shape. Such stimulus can be heating above the switching temperature of the material.

The anti-static additive compound consists of a masterbatch which comprises partial polymeric matrix based in the shape memory polymer and the additives which provide electrostatic dissipative properties.

Under this application, a masterbatch is considered to be a plastic composite of one or more additives in high concentration to be blended in varying percentages with the plastic to be shaped. The masterbatch can be solid or liquid. Typically, the masterbatch plastic compound may be wax based (universal) or based on a specific polymer, which is identical or compatible with the polymer to which the masterbatch is to be added. In this way, a better adhesion and distribution of the masterbatch in the polymer matrix is assured. With regard to the additives, these may vary depending on the functionality to be added to the plastic to be shaped, for example, colour, flame retardant, plasticizers, etc. Under this application, the polymeric matrix constituting the masterbatch is identical to the polymer matrix of the Shape Memory Polymer (SMP) and that, in order to guarantee a surface resistance value in the dissipative static range, a masterbatch can be used whose additive is an anti-static agent to enhance these properties. The anti-static additive is selected from carbon black or carbon nanotubes, conductive fibers, nanomaterials, among others.

The shape memory polymer consists of a material which can be polyurethane or polyethylene based and is suitable for conventional moulding processes, as extrusion or even injection moulding.

The anti-static additive compound is used in a percentage range between 1% and 8% in relation to the shape memory polymer weight.

The process cycle representation is depicted in Figure 1.

The stackable tray is formed completely from a shape memory polymer composite composed by the shape memory polymer (1) and the anti-static additive (2) compound. The shape memory polymer composite is generally deformable from a permanent shape (3), which corresponds to a memorized shape of the polymer, to a temporary shape (4), referent to a deformed, non-memorized shape of the polymer, and vice versa.

The process to generate the permanent shape (3) begins with the mixing of a percentage range between 1% and 8% of anti-static additive (2) with the shape memory polymer (1) by means of a polymer mixer. The raw material mixture is provided to the extrusion machine through the hopper, and the material is both melted and trans versed along by the action of a rotary screw inside a heated barrel, with a temperature range between 160°C and 230°C,. Then, the molten polymer is forced into a die, which generates a constant cross section shape in the continuous length of the extruded polymeric sheet, which is then harden by cooling while simultaneously being pulled by adjacent rollers. In one embodiment, the cooling is made by air. In another embodiment, the cooling is made with a cooling bath.

The formed extruded polymeric sheet is then cut to size enabling both transportation and suitability to the next step of the manufacturing process. The sheet extrusion process allows the definition of the permanent shape (3), while assuring the ESD properties at the electrostatic dissipative range, with a surface resistance between 1E5 Ω and 1E8 Ω.

As previously explained, shape memory polymers are stimuli-responsive polymers that can significantly change specific properties, as in this particular case, shape (e.g. bending, substantial shrinkage, moulding to a pre-defined shape). The shape memory polymer presented here, functions in accordance to temperature imposition, as an external stimulus to trigger the change.

The following step, of the manufacturing process, resources to the thermoforming process of the polymeric extruded sheet to generate the intended shape. Briefly, the polymeric sheet is softened, by heat radiation, at a temperature range between 40°C to 80°C, until a pliable forming temperature is reached. Then, the softened sheet is pressed against a mould structure (5) mechanically, by means of an external stress combined with vacuum, acquiring a specific shape. Finally, the moulded sheet is cooled while maintaining the shape, shape fixity, generating this way, the usable product.

This temporary shape (4) is retained until the generated stackable tray is exposed to an appropriate stimulus, such as heating above the switching temperature of the material, which induces the recovery phenomenon to the permanent shape (3). During recovery, the movement occurring is predefined and it is referent to the previous mechanical deformation, which led to the temporary shape (4).

When the ESDS to be accommodated varies, the design configuration of the temporary shape (4) can be changed to best accommodate the product without damage. Once fully recovered to the permanent shape (3), the shape memory polymer composite sheet can be moulded again, with the same, or different mould design configuration by means of the thermoforming process as previously reported generating a new temporary shape (4).

The ability to recover the permanent shape (3) and to be reconfigured by means of a new thermoforming process using a new mould design configuration is what allows the cyclic part of the manufacturing process. This is greatly advantageous as it allows the reusability of the shape memory composite sheet for the safe and specialized accommodation of ESDS.

This description is of course not in any way restricted to the forms of implementation presented herein and any person with an average knowledge of the area can provide many possibilities for modification thereof without departing from the general idea as defined by the claims.

## Claims

1. Protective stackable tray for protecting electrostatic discharge sensitive devices against electrostatic charges comprising a shape memory polymer composite (1) and an anti-static additive compound (2);
wherein the shape memory polymer composite (1) is configured to be deformable from a permanent shape (3) corresponding to a memorized shape of the polymer, to a temporary shape (4) referent to a deformed, non-memorized shape of the polymer, and vice-versa;
the tray being **characterized in that** the anti-static additive compound (2) is present in a percentage between 1 to 8% in relation to the shape memory polymer (1) weight.

2. Protective stackable tray according to the previous claim, wherein the shape memory polymer composite (1) is polyurethane based.

3. Protective stackable tray according to claim 1, wherein the shape memory polymer composite (1) is polyethylene based.

4. Protective stackable tray according to any of the previous claim, wherein the anti-static additive compound (2) consists of a masterbatch which comprises partial polymeric matrix based in the shape memory polymer (1) and additives selected from carbon black or carbon nanotubes.

5. Process to produce the stackable tray for protecting electrostatic discharge sensitive devices against electrostatic charges described in claims 1 to 4, comprising the following steps:
- Definition of the permanent shape (3):
- mixing of anti-static additive compound (2) with the shape memory polymer (1);
- the raw material mixture is provided to the extrusion machine;
- the material is both melted and trans versed along by the action of a rotary screw inside a heated barrel;
- the molten polymer is forced into a die, which generates a constant cross section shape in the continuous length of the extruded polymeric sheet;
- the extruded polymeric sheet is hardened by cooling while simultaneously being pulled by adjacent rollers;
- the extruded polymeric sheet is then cut to size;
- Generation of the temporary shape (4);
- the polymeric sheet is softened, by heat radiation, until a pliable forming temperature is reached;
- the softened sheet is pressed against a mould structure mechanically and by means of vacuum, acquiring a specific shape;
- the moulded sheet is cooled while maintaining the shape; wherein the temporary shape (4) can be reverted to the permanent shape by exposing the tray to heating above the switching temperature of the material;
**characterized in that** the anti-static additive compound (2) is used in a percentage between 1% and 8% in relation to the shape memory polymer (1) weight

6. Process according to the previous claim, wherein the temperature range inside the heated barrel varies from 50°C near the hopper to 230°C near the die.

7. Process according to any of the claims 5 to 6, wherein the polymeric sheet is softened at a temperature that ranges between 40°C to 80°C.

## Patentansprüche

1. Stapelbare Schutzschale zum Schutz von Geräten mit Empfindlichkeit gegenüber der elektrostatischen Entladung vor elektrostatischen Aufladungen, bestehend aus einem Formgedächtnispolymer-Verbundwerkstoff (1) und einer antistatischen Additivverbindung (2),
worin der Formgedächtnispolymer-Verbundwerkstoff (1)
so konfiguriert ist, dass er von einer permanenten Form (3), die der gespeicherten Form des Polymers entspricht, in eine temporäre Form (4) umgeformt werden kann, die der verformten, nicht gespeicherten Form des Polymers entspricht, und umgekehrt;
worin die Schale **dadurch gekennzeichnet ist, dass**
die antistatische Additivverbindung (2)
in einem Prozentsatz zwischen 1 und 8 % im Verhältnis zum Gewicht des Formgedächtnispolymers (1) vorhanden ist.

2. Stapelbare Schutzschale gemäß dem vorhergehenden Anspruch, worin der Formgedächtnispolymer-Verbundwerkstoff (1) auf Polyurethan basiert ist.

3. Stapelbare Schutzschale gemäß Anspruch 1, worin der Formgedächtnispolymer-Verbundwerkstoff (1) auf Polyethylen basiert ist.

4. Stapelbare Schutzschale gemäß einem der vorhergehenden Ansprüche, worin die antistatische Additivverbindung (2) aus einem Masterbatch besteht, das die partielle Polymermatrix auf Basis des Formgedächtnispolymers (1) und Additive beinhaltet, die aus Ruß- oder Kohlenstoffnanoröhren ausgewählt wurden.

5. Verfahren zur Herstellung der stapelbaren Schale zum Schutz von Geräten mit Empfindlichkeit gegenüber der elektrostatischen Entladung vor elektrostatischen Aufladungen gemäß den Ansprüchen 1 bis 4, bestehend aus folgenden Schritten:
- Bestimmung der permanenten Form (3):
- Mischung der antistatischen Additivverbindung (2) mit dem Formgedächtnispolymer (1);
- wobei die Rohstoffmischung der Extrusionsmaschine zugeführt wird;
- durch die Einwirkung einer rotierenden Schnecke in einem beheizten Zylinder wird der Werkstoff sowohl geschmolzen als auch befördert;
- das geschmolzene Polymer wird in eine Matrize gepresst, die eine konstante Querschnittsform durchgehender Länge aus der extrudierten Polymerfolie erzeugt;
- die extrudierte Polymerfolie wird durch Abkühlen gehärtet während sie gleichzeitig von danebenliegenden Rollen gezogen wird;
- danach wird die extrudierte Polymerfolie zugeschnitten;
- Erzeugung der temporären Form (4):
- Die Polymerfolie wird durch Wärmestrahlung erweicht, bis eine geschmeidige Verformungstemperatur erreicht wird;
- die erweichte Folie wird mechanisch und durch Vakuum gegen eine Formvorrichtung gepresst, wobei sie eine spezifische Form erlangt;
- die geformte Folie wird unter Beibehaltung der Form abgekühlt;
wobei die temporäre Form (4) in die permanente Form zurückverwandelt werden kann, indem die Schale einer Erwärmung oberhalb der Schalttemperatur des Materials ausgesetzt wird;
**dadurch gekennzeichnet, dass** die antistatische Additivverbindung (2) in einem Prozentsatz zwischen 1 % und 8 % bezogen auf das Gewicht des Formgedächtnispolymers (1) verwendet wird.

6. Verfahren gemäß dem vorhergehenden Anspruch, worin der Temperaturbereich innerhalb des erhitzten Zylinders von 50 °C in der Nähe des Einfülltrichters bis 230 °C in der Nähe der Matrize variiert.

7. Verfahren gemäß einem der Ansprüche 5 bis 6, worin die Polymerfolie bei einer Temperatur erweicht wird, die zwischen 40 °C und 80 °C liegt.

## Revendications

1. Plateau de protection empilable pour la protection de dispositifs sensibles aux décharges électrostatiques contre les charges électrostatiques comprenant un composite polymère à mémoire de forme (1) et un composé additif antistatique (2) ;
dans lequel le composite polymère à mémoire de forme (1)
est configuré pour être déformable à partir d'une forme permanente (3) correspondant à une forme mémorisée du polymère, jusqu'à une forme temporaire (4) référente à une forme déformée non mémorisée du polymère, et vice versa ;
le plateau étant **caractérisé en ce que**
le composé additif antistatique (2) est présent
en un pourcentage compris entre 1 et 8 % par rapport au poids du polymère à mémoire de forme (1).

2. Plateau de protection empilable selon la revendication précédente, dans lequel le composite polymère à mémoire de forme (1) est à base de polyuréthane.

3. Plateau de protection empilable selon la revendication 1, dans lequel le composite polymère à mémoire de forme (1) est à base de polyéthylène.

4. Plateau de protection empilable selon l'une quelconque des revendications précédentes, dans lequel le composé additif antistatique (2) est constitué d'un mélange maître qui comprend une matrice polymérique partielle à base du polymère à mémoire de forme (1) et des additifs sélectionnés parmi le noir de carbone ou les nanotubes de carbone.

5. Procédé de réalisation du plateau empilable de protection de dispositifs sensibles aux décharges électrostatiques contre les charges électrostatiques décrit selon les revendications 1 à 4, comprenant les étapes suivantes :
- définition de la forme permanente (3) :
- mélange du composé additif antistatique (2) avec le polymère à mémoire de forme (1) ;
- le mélange de matières premières est fourni à la machine d'extrusion ;
- le matériau est à la fois fondu et transvasé par l'action d'une vis rotative à l'intérieur d'un cylindre chauffé ;
- le polymère fondu est introduit dans une matrice, ce qui génère une forme de section transversale constante dans la longueur continue de la feuille polymérique extrudée ;
- la feuille polymérique extrudée est solidifiée par refroidissement tandis qu'elle est simultanément tirée par des rouleaux adjacents ;
- la feuille polymérique extrudée est alors découpée sur mesure ;
- génération de la forme temporaire (4) ;
- la feuille polymérique est ramollie, par rayonnement thermique, jusqu'à ce qu'une température de formage pliable soit atteinte ;
- la feuille ramollie est pressée contre une structure de moule de manière mécanique et au moyen d'un vide, en acquérant une forme spécifique ;
- la feuille moulée est refroidie tandis que la forme est maintenue ;
dans lequel la forme temporaire (4) peut être rétablie à la forme permanente par l'exposition du plateau à un chauffage au-dessus de la température de commutation du matériau ;
**caractérisé en ce que** le composé additif antistatique (2) est utilisé dans un pourcentage compris entre 1 % et 8 % par rapport au poids du polymère à mémoire de forme (1).

6. Procédé selon l'une quelconque des revendications précédentes, dans lequel la plage de température à l'intérieur du cylindre chauffé varie de 50 °C près de la trémie jusqu'à 230 °C près de la matrice.

7. Procédé selon l'une quelconque des revendications 5 à 6, dans lequel la feuille polymérique est assouplie à une température qui est comprise entre 40 °C et 80 °C.
